# DEMANDE DE BREVET EUROPEEN

(11) **EP 2 495 866 A1**
(43) Date de publication de la demande: **05.09.2012**
(21) Numéro de dépôt: 12354011.4
(22) Date de dépôt: 23.02.2012
(51) Int. Cl.: H02N 1/00, B81B 3/00

(54) **Actionneur électrostatique d'une structure mobile à relaxation améliorée des charges piégées**

(30) Priorité: 04.03.2011 FR 1100664
(71) Demandeur: Commissariat à l'Énergie Atomique et aux Énergies Alternatives, 75015 Paris (FR)
(72) Inventeur: Nowodzinski, Antoine, 38330 Saint-Ismier (FR)
(74) Mandataire: Talbot, Alexandre

(57) **Abrégé**

Le dispositif comporte un premier plot d'actionnement (5) en matériau électriquement conducteur avec une première surface de contact. Un second plot d'actionnement (6) en matériau électriquement conducteur fait face au premier plot d'actionnement (5). Un circuit d'actionnement (7) électrostatique déplacent les plots d'actionnement (5, 6) l'un par rapport à l'autre entre une première position et une autre position. Le circuit d'actionnement (7) comporte un dispositif d'application d'un potentiel plus important sur le second plot d'actionnement (6) que sur le premier plot d'actionnement (5). Un film (8) en matériau électriquement isolant réalise l'isolation électrique entre les premier (5) et second (6) plots. Le film (8) en matériau électriquement isolant comporte une interface avec une source (11) en ions positifs et est perméable auxdits ions positifs. La source en ions positifs (11) est dépourvue de vapeur d'eau.

## Description

### Domaine technique de l'invention

L'invention est relative à un actionneur électrostatique d'une structure mobile telle qu'un interrupteur électrostatique, une membrane mobile d'un capteur ou d'une source acoustique, l'actionneur comportant des premier et deuxième plots entre lesquels un champ électrique est créé.

### État de la technique

Les systèmes micro-électromécaniques (MEMS) se sont développés au fur et à mesure des années et ils sont maintenant présents dans de très nombreux secteurs technologiques.

L'intégration de ces dispositifs au plus près des puces électroniques permet un gain en compacité et en énergie consommée qui ouvre la voie à de nouvelles applications et à de nouveaux marchés.

Les dispositifs à actionnement électrostatiques occupent une place importante car ils sont faciles à réaliser, notamment pour former un dispositif de type interrupteur dans lequel un contact électrique intermittent est réalisé entre deux plots de contact.

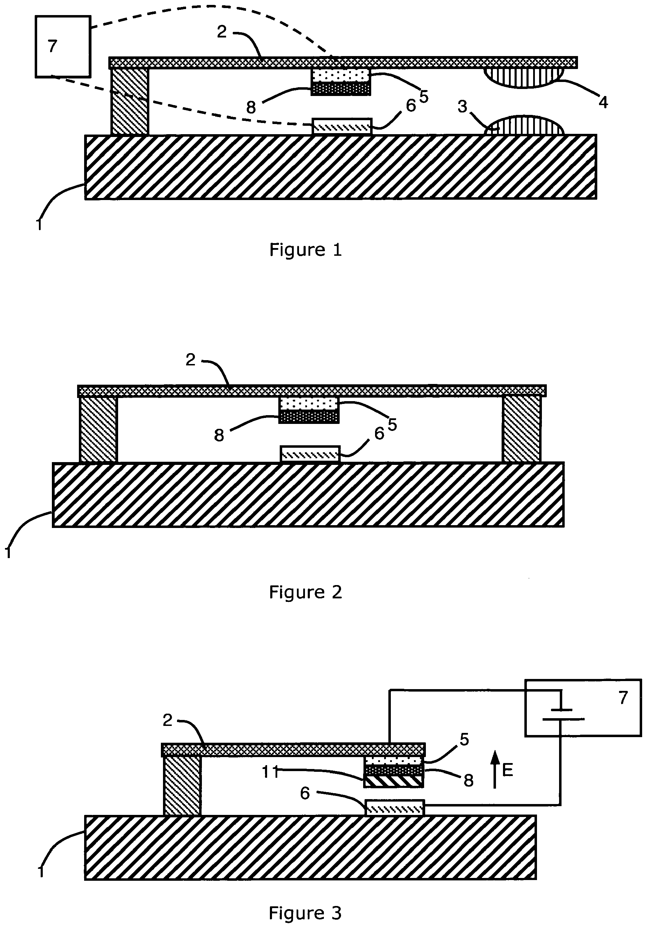

Comme cela est illustré à la figure 1, l'interrupteur comporte un substrat 1 muni d'un bras mobile 2 solidaire. Le substrat 1 comporte un premier plot de contact 3 associé à une première électrode. Le bras mobile 2 comporte un second plot de contact 4 associé à une seconde électrode. Le second plot de contact 4 se déplace entre une position d'isolation et une position de contact avec le premier plot de contact 3.

Des premier 5 et second 6 plots d'actionnement servent à l'actionnement du bras mobile 2 de manière électrostatique. Les premier 5 et second 6 plots de d'actionnement comportent chacun une partie électriquement conductrice et une différence de potentiel est appliquée entre les deux électrodes pour actionner le bras mobile. Un circuit d'actionnement 7 est utilisé pour déplacer la poutre mobile 2 par rapport au substrat 1. Un des plots d'actionnement est recouvert par un matériau électriquement isolant 8 de manière à éviter tout court-circuit entre les deux plots.

La différence de potentiel appliquée entre les deux plots 5 et 6 crée une force électrostatique qui entraîne le rapprochement des deux plots de contact. De cette manière, au moyen de l'application d'un champ électrique intermittent entre les deux plots d'actionnement, on obtient le déplacement entre l'électrode mobile et l'électrode fixe.

Au fur et à mesure de son utilisation, des charges électriques sont introduites et piégées dans la couche en matériau électriquement isolant 8 séparant les deux zones d'actionnement 5 et 6. Ces charges accumulées dans le matériau isolant 8 ont pour effet de créer un potentiel parasite qui modifie les conditions de fonctionnement du dispositif. Dans certains cas, l'interrupteur peut rester collé même lorsque la différence de potentiel entre les deux électrodes est nulle.

La publication de Zhen Peng et al., « Impact of Humidity on Dielectric Charging in RF MEMS Capacitive Switches » (IEEE Microwave and wireless components letters. Vol.19 N°5 May 2009) traite de l'effet de l'humidité sur les charges présentes dans les diélectriques disposés entre les deux électrodes d'un interrupteur capacitif.

Différents dispositifs sont réalisés avec deux types de diélectriques séparant les deux électrodes de l'interrupteur : un oxyde de silicium et un nitrure de silicium. Plusieurs atmosphères sont étudiées et la valeur de la tension de « pull-in » est analysée pour différentes conditions en fonction de la composition de l'atmosphère présente entre ces deux électrodes. L'auteur indique qu'une atmosphère trop sèche (<1 % humidité relative) a un effet négatif sur la durée de vie du dispositif.

### Résumé de l'invention

On constate qu'il existe un besoin de prévoir un dispositif muni d'un contact intermittent dont la dégradation des performances dans le temps est réduite et dont la réalisation est facile à mettre en oeuvre.

On tend à satisfaire ce besoin en prévoyant que le dispositif comporte :
- un premier plot en matériau électriquement conducteur avec une première surface de contact,
- un second plot en matériau électriquement conducteur avec une seconde surface de contact,
- un circuit d'actionnement électrostatique pour déplacer les premier et second plots l'un par rapport à l'autre, le circuit d'actionnement comportant des moyens d'application d'une différence de potentiel entre les premier et second plots,
- une source en ions positifs dépourvue de vapeur d'eau
- un film en matériau électriquement isolant réalisant l'isolation électrique entre les premier et second plots, le film en matériau électriquement isolant comportant une interface avec la source en ions positifs et étant perméable auxdits ions positifs.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1 illustre, en coupe, de manière schématique, un interrupteur,
- la figure 2 illustre, en coupe, de manière schématique, un capteur ou une source acoustique,
- la figure 3 illustre, en coupe, de manière schématique, un actionneur muni d'une électrode avec une source d'ions positifs,
- les figures 4 et 5 illustrent, en vue de coupe, de manière schématique, une partie de deux actionneurs ayant une source d'ions positifs approvisionnant un film électriquement isolant.

### Description d'un mode de réalisation préféré de l'invention

Comme illustré à la figure 1, le substrat 1 est muni d'un bras mobile 2 solidaire. Le substrat 1 comporte une première zone de contact 3, correspondant dans cet exemple à un plot de contact, associée à une première électrode. Le bras mobile 2 comporte une seconde zone de contact 4 qui correspond également dans cet exemple à un plot de contact et qui est associée à une seconde électrode. Le deuxième plot de contact 4 se déplace entre une position de contact avec le premier plot de contact 3 et une autre position, par exemple une position de repos ou une position de contact avec un autre plot de contact. Cette configuration correspond par exemple à un actionneur de type interrupteur ou à un capteur.

Dans une autre configuration illustrée à la figure 2, les plots de contacts ne sont pas présents et la poutre mobile 2 est une membrane qui sert, par exemple, de capteur ou de source acoustique.

Comme cela est illustré à la figure 3 qui ne représente qu'une partie du dispositif, l'actionneur électrostatique comporte des premier 5 et deuxième 6 plots d'actionnement qui sont mobiles l'un par rapport à l'autre. Les premier 5 et deuxième 6 plots d'actionnement se déplacent entre une première position qui est, par exemple, la position de contact commun des plots de contact 3 et 4 et une seconde position, par exemple une position de repos.

Dans la première position, il peut y avoir un contact physique entre les deux plots d'actionnement 5 et 6 ou une absence de contact physique car la poutre mobile 2 s'oppose à ce contact. Dans la première position, la distance entre les deux plots 5 et 6 est minimale. La seconde position peut correspondre à une position de repos ou à une répulsion de la poutre mobile 2 par rapport au substrat 1.

Dans un autre mode de réalisation non représenté, la position des premier 5 et second 6 plots d'actionnement est inversée par rapport au substrat 1.

Les premier 5 et deuxième 6 plots d'actionnement possèdent chacun une surface principale. Les faces principales des deux plots d'actionnement sont en regard. Dans le cas d'un contact entre les premier 5 et deuxième 6 plots d'actionnement une pression s'exerce sur les plots et sur un ou plusieurs éléments se trouvant entre les deux plots d'actionnement.

Le dispositif comporte un circuit d'actionnement électrostatique 7 pour déplacer les plots d'actionnement 5 et 6 l'un par rapport à l'autre entre la première position et une autre position.

Le circuit d'actionnement électrostatique 7 comporte un dispositif de génération d'un champ électrique entre les deux plots d'actionnement 5 et 6. Le champ électrique a pour effet de créer une force qui tend à rapprocher les deux plots d'actionnement 5 et 6 pour atteindre la première position.

Les premier 5 et deuxième 6 plots d'actionnement sont chacun en matériau électriquement conducteur, par exemple en matériau métallique ou semiconducteur dopé, qui intervient dans la génération du champ électrique E entre les deux plots d'actionnement. De cette manière, les lignes de champ électrique relient le premier plot 5 au deuxième plot 6.

Un film 8 en matériau électriquement isolant est disposé entre les premier 5 et deuxième 6 plots d'actionnement. Le film 8 électriquement isolant empêche tout contact électrique, tout court-circuit, entre les deux plots d'actionnement 5 et 6. En cas de contact commun, le premier 5 et deuxième 6 plots exercent une pression sur le film 8 électriquement isolant.

Le film 8 en matériau électriquement isolant est traversé par le champ électrique E. Le film 8 en matériau électriquement isolant comporte deux surfaces principales opposées qui font face aux plots d'actionnement. Le film 8 électriquement isolant comporte une pluralité de faces latérale qui relient les faces principales.

Le film 8 électriquement isolant réalise l'isolation électrique entre les premier 5 et deuxième 6 plots d'actionnement et présente une interface avec le premier plot d'actionnement 5 au moins par intermittence. Le contact physique entre le film 8 et le premier plot 5 peut avoir lieu dans la position de contact commun entre les deux plots 3 et 4 qu'il y ait ou pas contact entre les plots 5 et 6 ou alors durant le déplacement du premier plot 5 pour tendre vers la première position.

Selon les modes de réalisation utilisés, le film 8 en matériau électriquement isolant est disposé sur un des plots d'actionnement ou entre les deux plots d'actionnement. Une des faces principales du film 8 peut former la face qui recouvre le plot d'actionnement.

Le film 8 électriquement isolant peut être formé par un ou plusieurs matériaux électriquement isolants. Le film 8 électriquement isolant est, par exemple, un oxyde de silicium, un nitrure de silicium, un oxyde d'hafnium.

Le circuit d'actionnement électrostatique 7 pour déplacer les plots d'actionnement comporte un dispositif d'application d'une tension plus importante sur le deuxième plot d'actionnement 6 que sur le premier plot d'actionnement 5. De cette manière, le champ électrique existant entre les deux plots d'actionnement a son potentiel le plus bas (par exemple négatif) appliqué sur le premier plot d'actionnement 5 et son potentiel le plus haut (par exemple positif) appliqué sur le second plot d'actionnement 6. Le champ électrique est dirigé du deuxième plot 6 vers le premier plot 5, c'est-à-dire que le potentiel croît depuis le plot 5 vers le plot 6.

Dans cette configuration, lorsque la première position est obtenue, par exemple lors du contact physique entre le premier plot d'actionnement 5 et le second plot d'actionnement 6, c'est-à-dire quand le champ électrique E est le plus élevé, il y a injection de charges négatives depuis la partie électriquement conductrice du premier plot 5, par exemple des électrons, en direction du deuxième plot 6. L'injection de charge peut avoir lieu avant que la première position ne soit atteinte. Il suffit que le film 8 soit en contact avec le premier plot 5.

Les charges électriques négatives sont piégées par le film 8 électriquement isolant qui est en contact physique et donc électrique avec le premier plot 5.

Le film 8 électriquement isolant peut être disposé sur un des deux plots d'actionnement comme cela est illustré à la figure 2. Le film 8 fait alors partie de l'électrode mobile ou statique.

Un film additionnel 10 électriquement isolant peut également être utilisé sur le deuxième plot 6 en plus du film 8 sur le premier plot 5. Ce film additionnel 10 permet d'avoir les deux plots d'actionnement recouverts par un matériau électriquement isolant.

Le film additionnel 10 électriquement isolant permet de maîtriser l'épaisseur totale de matériau isolant qui est présent, au minimum, entre les deux plots d'actionnement. Cette précaution permet de maîtriser l'isolation électrique de la structure et la fiabilité du dispositif en évitant que le champ électrique E n'atteigne la valeur de seuil de claquage dans les couches électriquement isolantes 8 et/ou 10.

Le dispositif comporte une source 11 d'ions positifs qui est en contact avec le film 8 électriquement isolant. De manière préférentielle, les ions positifs sont choisis parmi H+, Li+, Ca+, K+ et Na+ car ils présentent une mobilité importante dans les matériaux utilisés couramment pour former le film 8 électriquement isolant. D'autres ions positifs sont envisageables. Les ions positifs se déplacent dans le film 8 électriquement isolant. La source 11 en ions positifs présente une interface avec le film 8 électriquement isolant qui est perméable aux ions émis. La source en ions positifs peut être dépourvue de vapeur d'eau.

La source d'ions positifs peut être sous forme solide, liquide ou gazeuse. De manière préférentielle, la source en ions positifs comporte une partie sous forme solide.

Les ions positifs pénètrent dans le film 8 électriquement isolant et ils sont attirés électrostatiquement jusqu'aux charges négatives piégées ce qui permet d'éliminer cette charge parasite en formant un élément électriquement neutre.

Comme les charges électriques négatives sont injectées depuis le premier plot d'actionnement 5, la plus grande partie des charges se trouvent proches de l'interface entre ces deux matériaux. Il est alors intéressant de placer les ions positifs rapidement à côté des charges pour les neutraliser. Dans ce but, l'actionneur peut comporter des moyens de rapprochement de la source d'ions positifs par rapport à l'interface entre le film 8 électriquement isolant et la source 11.

Ainsi, les ions positifs sont capables d'atteindre la majorité des charges électriques négatives disposées dans le coeur du film 8 électriquement isolant dans une période de temps raisonnable. Le film 8 électriquement isolant et les ions positifs sont choisis de manière à avoir une structure comportant un film perméable aux ions positifs sélectionnés.

Dans un premier mode de réalisation préférentiel, la surface principale du film 8 électriquement isolant n'est pas plane, elle comporte une structuration de surface. La structuration de surface correspond à une variation de l'épaisseur du matériau électriquement isolant. La structuration permet d'augmenter la surface développée du matériau électriquement isolant et donc de faciliter l'introduction d'une quantité importante d'ions positifs dans le film 8.

La partie épaisse du film 8 permet de maîtriser l'espace minimal qui existe entre les deux plots d'actionnement 5, 6. La partie d'épaisseur réduite permet de se rapprocher de l'interface entre le film 8 et la source 11 et d'accéder aux faces latérales de la partie épaisse.

En d'autres termes, le film 8 en matériau électriquement isolant comporte un film continu ayant une épaisseur constante qui est recouvert par une pluralité de motifs espacés les uns des autres. Le film continu en matériau isolant permet d'éviter un court-circuit entre les deux plots d'actionnement.

La structuration de surface se traduit par la présence d'un trou borgne dans le film 8 électriquement isolant qui débouche sur une de ses faces principales ou sur une face latérale. La source 11 en ions positifs est située au moins dans le trou borgne.

Le trou peut également prendre la forme d'une ou plusieurs tranchées qui débouchent sur une ou plusieurs faces latérales du film 8 isolant, l'axe longitudinal de la tranchée est donc parallèle aux faces principales. De manière préférentielle, le trou et/ou la tranchée s'enfoncent sur au moins la moitié de l'épaisseur du film 8 électriquement isolant afin de favoriser le transit des ions positifs dans le film 8 et atteindre plus facilement les charges négatives piégées.

Le trou peut également être un trou traversant qui relie deux faces latérales.

Le ou les trous ou tranchées formés dans le film 8 électriquement isolant sont de forme quelconque.

La source 11 en ions positifs est disposée dans le trou et donc s'enfonce dans le film 8 électriquement isolant. De cette manière, la distance séparant la source en ions positifs de l'interface entre le premier contact électrique et le film 8 isolant est réduite. Lorsque le film 8 comporte une zone mince et une zone épaisse, la source 11 est avantageusement disposée au-dessus de la zone mince, c'est-à-dire dans l'épaisseur du film 8 défini par la zone épaisse.

De cette manière, les ions positifs atteignent plus facilement le coeur du film isolant 8. Ils ont plus de facilité à atteindre les charges piégées pour les éliminer.

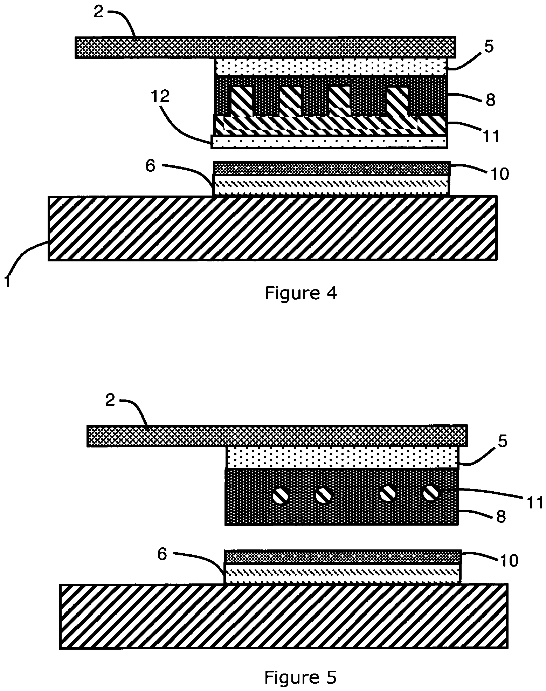

Dans une variante de réalisation du mode précédent et illustrée à la figure 4, la source 11 en ions positifs est recouverte par un matériau électriquement isolant, par exemple, un film de couverture 12. Cet empilement particulier permet d'isoler électriquement la source en ions positifs dans le cas où cette dernière est électriquement conductrice. Le film de couverture 12 permet également de limiter les interactions de la source 11 d'ions positifs avec l'extérieur. Dans un autre mode particulier de réalisation, le film de couverture est dans un matériau électriquement conducteur.

Dans un autre mode de réalisation préférentiel illustré à la figure 5 et qui peut être combiné aux modes précédents, le film 8 électriquement isolant comporte un ou des îlots ou des nodules en source 11 d'ions positifs. Les nodules en source 11 d'ions positifs sont complètement enrobés dans le film 8. Ainsi, les nodules sont directement disposés au coeur du film 8 ce qui réduit, pour les ions positifs, la distance à parcourir afin d'atteindre les charges piégées.

La source 11 d'ions positifs est, par exemple, une atmosphère gazeuse contenant de l'hydrogène. La source 11 d'ions positifs peut être un matériau sous forme solide, liquide ou gazeux qui contient du lithium, du calcium, du potassium ou du sodium dans une forme pouvant libérer les ions recherchés.

Dans un mode de réalisation préférentiel, l'atmosphère gazeuse est associée à une source d'ions positifs sous forme solide ce qui permet de mieux maîtriser l'apport en ions positif et la conservation des ions positifs. De manière préférentielle, la source solide comporte des sources d'ions Li+, Ca+, K+ et Na+ qui permettent de délivrer une quantité plus importante d'ions qu'une atmosphère à base d'hydrogène. La source en ions positifs peut comporter une partie sous forme solide et une partie sous une autre forme.

Dans un mode de réalisation particulier, la source 11 d'ions positifs est un film de lithium, de calcium, de potassium ou de sodium ou un de leurs alliages qui est déposé sur le film 8 électriquement isolant pour fournir les ions désirés.

Dans un autre mode de réalisation, le dispositif comporte une enceinte préférentiellement étanche de manière à maitriser l'atmosphère de fonctionnement des contacts électriques.

Afin de maîtriser l'approvisionnement en ions positifs lorsque la source est sous forme liquide ou gazeuse, il est intéressant d'utiliser un matériau réservoir qui réalise le conditionnement de la source d'ions positif sans gêner le transit des ces ions.

Dans un mode de réalisation particulier, la source 11 en ions positifs est formée par un matériau réservoir qui est rempli par un matériau liquide ou gazeux apte à libérer les ions désirés. Le matériau réservoir peut être un matériau poreux, par exemple du silicium poreux, qui est rempli par un matériau apte à fournir des ions positifs. Le film 8 électriquement isolant est recouvert au moins partiellement par le matériau réservoir (figures 3 et 4) ou le matériau réservoir est introduit dans le film 8 isolant (figure 5). Le matériau réservoir est rempli par un matériau apte à fournir des ions positifs, par exemple de l'eau, de la vapeur d'eau, un matériau à base de lithium, de calcium, de potassium ou de sodium.

Dans un mode de réalisation préférentiel, le matériau réservoir remplit le trou formé dans le film 8 électriquement isolant. Ainsi, les ions positifs sont placés au plus près du coeur du film électriquement isolant.

Dans une variante de réalisation, le matériau réservoir est recouvert par le film de couverture 12 électriquement isolant.

Le film de couverture 12 permet de recouvrir le matériau réservoir et de limiter les fuites en ions positifs ou en matériau source hors du film 8 électriquement isolant. Ce point est particulièrement intéressant lorsqu'un getter est utilisé dans l'enceinte délimitant l'atmosphère de travail de la poutre mobile 2 et que le getter réagit avec le matériau fournissant les ions positifs.

Dans un autre mode de réalisation, une source additionnelle d'ions positifs est intégrée sur le deuxième plot d'actionnement 6 avec le film 10, si les électrons peuvent être injectées jusqu'au film 10 électriquement isolant. Ce qui a été décrit pour le premier plot 5 peut alors être utilisé pour le second plot d'actionnement 6.

## Revendications

1. Actionneur électrostatique comportant :
- un premier plot (5) en matériau électriquement conducteur avec une première surface de contact,
- un second plot (6) en matériau électriquement conducteur avec une seconde surface de contact,
- un circuit d'actionnement (7) électrostatique pour déplacer les premier et second plots (5, 6) l'un par rapport à l'autre, le circuit d'actionnement comportant des moyens d'application d'une différence de potentiel entre les premier et second plots (5, 6),
- un film (8) en matériau électriquement isolant réalisant l'isolation électrique entre les premier (5) et second (6) plots,
actionneur **caractérisé en ce qu'**il comporte une source en ions positifs dépourvue de vapeur d'eau et **en ce que** le film (8) en matériau électriquement isolant comporte une interface avec la source (11) en ions positifs et est perméable auxdits ions positifs.

2. Actionneur selon la revendication 1, **caractérisé en ce que** le film (8) électriquement isolant comporte un trou borgne et la source (11) en ions positifs est située au moins dans le trou borgne.

3. Actionneur selon l'une des revendications 1 et 2, **caractérisé en ce que** la source (11) en ions positifs forme au moins un nodule enrobé dans le film (8) électriquement isolant.

4. Actionneur selon l'une quelconque des revendications 1 à 3, **caractérisé en ce que** les ions positifs sont choisis parmi les ions de l'hydrogène, du lithium, du sodium, du potassium et du calcium.

5. Actionneur selon l'une quelconque des revendications 1 à 4, **caractérisé en ce que** la source (11) en ions positifs est formée par un matériau poreux remplit par un matériau liquide ou gazeux libérant les ions positifs.

6. Actionneur selon l'une des revendications 4 et 5, **caractérisé en ce que** la source (11) en ions positifs est sous forme solide.

7. Actionneur selon l'une quelconque des revendications 1 à 6, **caractérisé en ce que** les premier et second plots (5, 6) sont disposés dans une cavité fermée comportant un getter de la vapeur d'eau.

8. Actionneur selon la revendication 7, **caractérisé en ce qu'**une couche de couverture (12) recouvre la source (11) en ions positifs.

9. Dispositif selon l'une quelconque des revendications 1 à 8, **caractérisé en ce que** le film (8) électriquement isolant est situé sur le plot d'actionnement soumis au potentiel le plus faible, l'autre plot d'actionnement (6) étant recouvert par un film additionnel (10) électriquement isolant.

10. Actionneur selon l'une quelconque des revendications 1 à 8, **caractérisé en ce qu'**une source additionnelle en ions positifs approvisionne le film additionnel (10) électriquement isolant.
